# EUROPEAN PATENT APPLICATION

(11) **EP 4 838 558 A1**
(43) Date of publication of application: **11.11.2026**
(21) Application number: 24914871.9
(22) Date of filing: 03.09.2024
(51) Int. Cl.: H01L 23/373

(54) **CHIP PACKAGE STRUCTURE, ELECTRONIC DEVICE, AND MANUFACTURING METHOD FOR CHIP PACKAGE STRUCTURE**

(30) Priority: 04.01.2024 CN 202410016968
(71) Applicant: Huawei Technologies Co., Ltd., Shenzhen, Guangdong 518129 (CN)
(72) Inventor: ZHOU, Tianshen, Shenzhen, Guangdong 518129 (CN); WANG, Jiaming, Shenzhen, Guangdong 518129 (CN); CHIANG, Shanghsuan, Shenzhen, Guangdong 518129 (CN); HUANG, Bencheng, Shenzhen, Guangdong 518129 (CN)
(74) Representative: Maiwald GmbH
(86) International application number: PCT/CN2024/116628
(87) International publication number: WO 2025/145649

(57) **Abstract**

This application provides a chip packaging structure, an electronic device, and a manufacturing method for the chip packaging structure. The chip packaging structure includes a first carrier board, a first chip, a second carrier board, and a second chip that are sequentially stacked. The first chip is electrically connected to the first carrier board, and the second chip is electrically connected to the first carrier board through the second carrier board. The chip packaging structure further includes a first thermal conductor, the first thermal conductor is stacked between the first chip and the second chip, and a gap exists between the first thermal conductor and the second chip. The chip packaging structure further includes a bonding layer, the bonding layer is located on a side that is of the second chip and that faces the second carrier board, and a part of the bonding layer is located in the gap. In this application, heat dissipation effect of the chip packaging structure can be improved, thereby reducing thermal resistance, and avoiding thermal throttling of the second chip.

## Description

### TECHNICAL FIELD

This application relates to the field of semiconductor technologies, and in particular, to a chip packaging structure, an electronic device, and a manufacturing method for the chip packaging structure.

### BACKGROUND

An electronic device such as a mobile phone or a watch usually includes a system on chip (system on chip, SoC) and a double data rate (double data rate, DDR) synchronous dynamic random access memory (Synchronous Dynamic Random Access Memory, SDRAM), and the SoC and the DDR SDRAM need to be packaged. For example, fan-out package on package (fan-out package on package, FOPoP) is used for packaging. Therefore, the SoC and DDR SDRAM are stacked.

In a related technology, a film layer and an adhesive layer are disposed between the SoC and the DDR SDRAM, and thermal conductivity of the film layer and thermal conductivity of the adhesive layer are both poor. As a result, it is difficult for the DDR SDRAM to dissipate heat, leading to thermal throttling of the DDR SDRAM.

### SUMMARY

To resolve the foregoing technical problem, this application provides a chip packaging structure, an electronic device, and a manufacturing method for the chip packaging structure, so that heat dissipation effect of the chip packaging structure can be improved, thereby reducing thermal resistance, and avoiding thermal throttling of a second chip.

According to a first aspect of this application, a chip packaging structure is provided, including: a first carrier board, a first chip, a second carrier board, and a second chip that are sequentially stacked. The first chip is electrically connected to the first carrier board. The second chip is electrically connected to the first carrier board through the second carrier board. For example, the chip packaging structure further includes a conductor, and the conductor is connected between the second carrier board and the first carrier board. The chip packaging structure further includes a first thermal conductor and a bonding layer. The first thermal conductor is stacked between the first chip and the second chip, and a gap exists between the first thermal conductor and the second chip. The bonding layer is located on a side that is of the second chip and that faces the second carrier board, and a part of the bonding layer is located in the gap between the second chip and the first thermal conductor.

In an application process of the chip packaging structure, the second chip generates heat, and the bonding layer is located on the side that is of the second chip and that faces the second carrier board. Therefore, the second chip conducts the generated heat to the bonding layer. Because the first thermal conductor is located between the first chip and the second chip, and the part of bonding layer is located in the gap between the second chip and the first thermal conductor, the bonding layer may conduct, to the first thermal conductor, the heat conducted by the second chip, and the first thermal conductor dissipates the heat. In addition, heat may be dissipated in a length direction and a width direction of the first thermal conductor, so that heat dissipation effect of the chip packaging structure can be improved, thereby reducing thermal resistance, and avoiding thermal throttling of the second chip.

In some implementations, the chip packaging structure further includes a second thermal conductor. The second thermal conductor is in contact with a surface that is of the first chip and that faces the second carrier board. In an application process of the chip packaging structure, the first chip also generates heat, and the second thermal conductor is in contact with the first chip. Therefore, the first chip may conduct the generated heat to the second thermal conductor, and dissipate the heat in a length direction and a width direction of the second thermal conductor. In this way, heat dissipation effect of the chip packaging structure can be further improved, thereby reducing thermal resistance, and avoiding thermal throttling of the first chip.

In addition, the second carrier board includes a dielectric structure and a first conductive portion, at least a part of the first conductive portion is disposed in the dielectric structure, and the first thermal conductor and the second thermal conductor are separately connected to the first conductive portion. A material of the first conductive portion is usually metal, and the metal has good thermal conductivity. Therefore, the second thermal conductor may conduct heat to the first thermal conductor through the first conductive portion, so that the first thermal conductor, the first conductive portion, and the second thermal conductor jointly dissipate heat, thereby further improving heat dissipation effect.

Further, a thickness of the first thermal conductor is greater than a thickness of the second thermal conductor. In this way, after the first chip conducts heat to the first thermal conductor through the second thermal conductor and the first conductive portion, the first thermal conductor may dissipate the heat. Because the thickness of the first thermal conductor is greater than the thickness of the second thermal conductor, the first thermal conductor may dissipate heat in a height direction, thereby further improving heat dissipation effect.

Based on this, the second carrier board further includes a second conductive portion, at least a part of the second conductive portion is disposed in the dielectric structure, a surface facing the second conductive portion is exposed from the dielectric structure and is connected to the second conductive portion, and the second conductive portion is electrically isolated from the first conductive portion. The first carrier board may also include a dielectric structure and a first conductive portion and a second conductive portion that are disposed on the dielectric structure, and the first conductive portion of the first carrier board is connected to the first chip. The second conductive portion of the second carrier board is connected to the second conductive portion of the first carrier board through the conductor. Therefore, the second carrier board can implement heat conduction between the first thermal conductor and the second thermal conductor, and can also implement a connection between the second chip and the first carrier board.

For a structure of the first conductive portion, in a possible implementation, the first conductive portion includes a metal block, and a thickness of the metal block is the same as a thickness of the second carrier board. In other words, both a surface that is of the first conductive portion and that faces the first chip and a surface that is of the first conductive portion and that faces the second chip may be of a same size as a surface that is of the second chip and that faces the first conductive portion. Because the first conductive portion can achieve thermal conduction effect, a thermal conduction area of the first conductive portion can be increased by using the structure, thereby increasing thermal conduction effect of the first conductive portion. In addition, a contact area between the first conductive portion and the second thermal conductor is larger, and a contact area between the first conductive portion and the first thermal conductor is larger. Therefore, the first conductive portion can also quickly conduct, to the first thermal conductor, heat conducted by the second thermal conductor, thereby facilitating quick heat dissipation.

In another possible implementation, the first conductive portion includes a metal layer and a connection portion, a thickness of the metal layer is less than a thickness of the second carrier board, and the metal layer is separately connected to the second thermal conductor and the first thermal conductor through the connection portion. For example, the metal layer is located in a middle of the second carrier board in a thickness direction, there may be a plurality of connection portions, a part of the plurality of connection portions are located between the metal layer and the first thermal conductor, and the other part of the plurality of connection portions are located between the metal layer and the second thermal conductor. Therefore, heat conduction between the first thermal conductor and the second thermal conductor can be implemented.

In some implementations, the chip packaging structure further includes a third thermal conductor, the third thermal conductor is located on a side that is of the second carrier board and that faces away from the first carrier board, and the third thermal conductor is thermally connected to the first conductive portion. The thermal connection may indicate a direct connection or a connection through the thermal conductor. In this way, after the first thermal conductor and the second thermal conductor conduct heat to the first conductive portion, the first conductive portion may conduct the heat to the third thermal conductor, and the third thermal conductor dissipates the heat. That is, the first thermal conductor, the first conductive portion, the second thermal conductor, and the third thermal conductor may jointly dissipate the heat, thereby further improving heat dissipation effect.

Based on this, the chip packaging structure further includes a third carrier board stacked between the second carrier board and the second thermal conductor, and the third thermal conductor is located on a side that is of the third carrier board and that faces away from the second carrier board. The third carrier board includes a dielectric structure and a conductive structure, at least a part of the conductive structure is disposed in the dielectric structure, and the conductive structure is separately connected to the second thermal conductor, the third thermal conductor, and the first conductive portion. The second thermal conductor may conduct heat to the third thermal conductor sequentially through the first conductive portion of the second carrier board and the conductive structure of the third carrier board, and the first thermal conductor may conduct heat to the third thermal conductor through the conductive structure of the third carrier board, so that the second thermal conductor, the first conductive portion of the second carrier board, the conductive structure of the third carrier board, the first thermal conductor, and the third thermal conductor jointly dissipate heat, thereby further improving heat dissipation effect.

In addition, the conductive structure includes a first conductive portion and a second conductive portion that are disposed in a first direction, and a communication portion connected between the first conductive portion and the second conductive portion, the first conductive portion of the conductive structure corresponds in position to and is connected to the first conductive portion of the second carrier board, the third thermal conductor is disposed on the second conductive portion, and an included angle exists between the first direction and a thickness direction of the chip packaging structure. Therefore, the second thermal conductor may conduct heat to the first thermal conductor sequentially through the first conductive portion of the second carrier board and the first conductive portion of the third carrier board, and the second thermal conductor may further conduct the heat to the third thermal conductor sequentially through the first conductive portion of the second carrier board, the first conductive portion of the third carrier board, the communication portion, and the second conductive portion of the third carrier board.

For a structure of the first conductive portion of the conductive structure, in a possible implementation, the first conductive portion of the conductive structure includes a metal block, and a thickness of the metal block of the conductive structure is the same as a thickness of the third carrier board. A surface that is of the first conductive portion and that faces the second chip is a complete surface, and a surface that is of the first conductive portion and that faces the second carrier board is also a complete surface. Because the first conductive portion can perform a thermal conduction function, a thermal conduction area of the first conductive portion can be increased by using the structure, thereby increasing thermal conduction effect of the first conductive portion. In addition, a contact area between the first conductive portion and the first thermal conductor is larger. This can also achieve better thermal conduction effect.

In another possible implementation, the first conductive portion of the conductive structure includes a metal layer and a connection portion, a thickness of the metal layer of the conductive structure is less than a thickness of the third carrier board, and the metal layer is connected to the first thermal conductor and the first conductive portion of the second carrier board through the connection portion. For example, the metal layer is located in the middle of the second carrier board in the thickness direction, there may be a plurality of connection portions, a part of the plurality of connection portions are located between the metal layer and the second carrier board, and the other part of the plurality of connection portions are located between the metal layer and the first thermal conductor. Therefore, heat of the second thermal conductor conducted through the second carrier board can be conducted to the first thermal conductor through the metal layer.

In some implementations, the chip packaging structure further includes a second thermal conductor, the first thermal conductor and the second thermal conductor are stacked between the first chip and the second chip, and a thickness of the first thermal conductor is greater than a thickness of the second thermal conductor. In this way, the first chip may conduct generated heat to the second thermal conductor, and the second thermal conductor conducts the heat to the first thermal conductor. Therefore, the first thermal conductor and the second thermal conductor may jointly dissipate heat for the chip packaging structure. Because the second thermal conductor is located above the first chip, and a thickness of the first chip is greater than a thickness of the second chip, the second thermal conductor may assist the first chip in heat dissipation along a height direction, thereby further improving heat dissipation effect.

Based on this, the chip packaging structure further includes a connection layer stacked between the first thermal conductor and the second thermal conductor. In this way, when the chip packaging structure is manufactured, the first thermal conductor may be fastened to the second thermal conductor through the connection layer, thereby facilitating fastening of the first thermal conductor to the second thermal conductor.

Further, the connection layer is a silver paste layer or a solder layer. Because a material of silver paste is silver, which belongs to metal, a material of the solder layer is usually tin, which also belongs to the metal, and the metal has good thermal conductivity, after the first chip conducts heat to the second thermal conductor, the second thermal conductor may better conduct the heat to the first thermal conductor through the connection layer, so that the first thermal conductor, the connection layer, and the second thermal conductor jointly dissipate the heat. Therefore, when the connection layer is the silver paste layer or the solder layer, heat can be better conducted between the second thermal conductor and the first thermal conductor, thereby further improving heat dissipation effect of the chip packaging structure.

Further, a via is provided on the second carrier board, and a part of the first thermal conductor is located in the via. In this way, the via provided on the second carrier board can provide avoiding space for the first thermal conductor, thereby facilitating disposing of the first thermal conductor between the first chip and the second chip.

In addition, a top surface of the first thermal conductor is higher than a top surface of the second carrier board. In other words, a surface that is of the first thermal conductor and that faces away from the first carrier board is higher than a surface that is of the second carrier board and that faces away from the first carrier board. In addition, a surface that is of the first heat body and that faces the first carrier board is further lower than or equal to a surface that is of the second carrier board and that faces the first carrier board. That is, the thickness of the first thermal conductor is greater than the thickness of the second carrier board. A larger thickness of the first thermal conductor indicates a larger heat dissipation area of the first thermal conductor. In this way, heat dissipation effect of the first thermal conductor can be improved.

In some implementations, a material of the first thermal conductor includes metal or silicon. For example, the material of the first thermal conductor includes metal, for example, copper or aluminum. Because the metal has good thermal conductivity, when the material of the first thermal conductor includes the metal, thermal conduction and heat dissipation can be better implemented, thereby further improving heat dissipation effect of the chip packaging structure. A material of the second thermal conductor may also include metal or silicon.

In addition, a material of the third thermal conductor includes metal or silicon. Similarly, when the material of the third thermal conductor includes metal, thermal conduction and heat dissipation can be better implemented, thereby further improving heat dissipation effect of the chip packaging structure.

According to a second aspect of this application, an electronic device is provided, including a circuit board and the chip packaging structure in any one of the foregoing implementations. The chip packaging structure is electrically connected to the circuit board. The electronic device can implement all effects of the chip packaging structure.

According to a third aspect of this application, a manufacturing method for a chip packaging structure is provided. The manufacturing method includes: manufacturing a first carrier board on a base plate; fastening a first chip to the first carrier board; manufacturing a second carrier board on the first carrier board; manufacturing a first thermal conductor; fastening a second chip to the second carrier board, where the first thermal conductor is located between the first chip and the second chip, and a gap exists between the first thermal conductor and the second chip; manufacturing a bonding layer on a side that is of the second chip and that faces the second carrier board, where a part of the bonding layer is located between the second chip and the first thermal conductor; and removing the base plate.

In an application process of the chip packaging structure, the second chip generates heat, and the bonding layer is located on the side that is of the second chip and that faces the second carrier board. Therefore, the second chip conducts the generated heat to the bonding layer. Because the first thermal conductor is located between the first chip and the second chip, and the part of bonding layer is located in the gap between the second chip and the first thermal conductor, the bonding layer may conduct, to the first thermal conductor, the heat conducted by the second chip, and the first thermal conductor dissipates the heat. In addition, heat may be dissipated in a length direction and a width direction of the first thermal conductor, so that heat dissipation effect of the chip packaging structure can be improved, thereby reducing thermal resistance, and avoiding thermal throttling of the second chip.

In some implementations, after the step of fastening the first chip to the first carrier board, the manufacturing method further includes: manufacturing a second thermal conductor on the first chip, where the second thermal conductor is located between the first thermal conductor and the first chip, and a thickness of the second thermal conductor is less than a thickness of the first thermal conductor. In an application process of the chip packaging structure, the first chip also generates heat, and the second thermal conductor is in contact with the first chip. Therefore, the first chip may conduct the generated heat to the second thermal conductor, and dissipate the heat through the second thermal conductor. In this way, heat dissipation effect of the chip packaging structure can be further improved, thereby reducing thermal resistance, and avoiding thermal throttling of the first chip.

In addition, the second carrier board includes a dielectric structure and a first conductive portion, at least a part of the first conductive portion is disposed in the dielectric structure, and the first conductive portion is connected to the second thermal conductor; and the step of manufacturing the first thermal conductor includes: manufacturing the first thermal conductor on the dielectric structure and the first conductive portion. In this way, the first thermal conductor and the second thermal conductor may be connected through the first conductive portion. A material of the first conductive portion is usually metal, and the metal has good thermal conductivity. Therefore, the second thermal conductor may conduct heat to the first thermal conductor through the first conductive portion, so that the first thermal conductor, the first conductive portion, and the second thermal conductor jointly dissipate heat, thereby further improving heat dissipation effect.

Based on this, after the step of manufacturing the second carrier board on the first carrier board, the manufacturing method further includes: manufacturing a third carrier board on the second carrier board, where the third carrier board includes a dielectric structure and a conductive structure, at least a part of the conductive structure is disposed in the dielectric structure, and the conductive structure is connected to the first conductive portion; and manufacturing a third thermal conductor on the third carrier board, where the conductive structure is connected to the third thermal conductor; and the step of manufacturing the first thermal conductor includes: manufacturing the first thermal conductor on the third carrier board, where the first thermal conductor is connected to the conductive structure. In this way, after the second thermal conductor and the first thermal conductor conduct heat to the first conductive portion, the first conductive portion may conduct the heat to the third thermal conductor, and the third thermal conductor dissipates the heat. That is, the first thermal conductor, the first conductive portion, the second thermal conductor, and the third thermal conductor may jointly dissipate the heat, thereby further improving heat dissipation effect.

### BRIEF DESCRIPTION OF DRAWINGS

To describe technical solutions in embodiments of this application more clearly, the following briefly describes accompanying drawings used in describing embodiments of this application. Clearly, the accompanying drawings in the following descriptions show merely some embodiments of this application, and a person of ordinary skill in the art may still derive other drawings from these accompanying drawings without creative efforts.
FIG. 1 is a diagram of a structure of a chip packaging structure according to a first embodiment of this application;
FIG. 2 is a diagram of a structure of a chip packaging structure according to a second embodiment of this application;
FIG. 3 is a cross-sectional view along A-A in FIG. 1;
FIG. 4 is a diagram of a structure of a chip packaging structure according to a third embodiment of this application;
FIG. 5 is a diagram of a structure of a chip packaging structure according to a fourth embodiment of this application;
FIG. 6 is a cross-sectional view along B-B in FIG. 5;
FIG. 7 is a cross-sectional view along C-C in FIG. 5;
FIG. 8 is another cross-sectional view along C-C in FIG. 5;
FIG. 9 is a diagram of a structure of a chip packaging structure according to a fifth embodiment of this application;
FIG. 10 is a schematic flowchart of a manufacturing method for the chip packaging structure shown in FIG. 1;
FIG. 11A to FIG. 11D are diagrams of a manufacturing process of a first part of steps in the manufacturing method shown in FIG. 10;
FIG. 12A to FIG. 12C are diagrams of a manufacturing process of a second part of steps in the manufacturing method shown in FIG. 10;
FIG. 13A and FIG. 13B are diagrams of a manufacturing process of a third part of steps in the manufacturing method shown in FIG. 10;
FIG. 14 is a schematic flowchart of a manufacturing method for the chip packaging structure in FIG. 2;
FIG. 15A to FIG. 15C are diagrams of a manufacturing process of a first part of steps in the manufacturing method shown in FIG. 14;
FIG. 16A to FIG. 16C are diagrams of a manufacturing process of a second part of steps in the manufacturing method shown in FIG. 14;
FIG. 17A to FIG. 17D are diagrams of a manufacturing process of a part of steps in another manufacturing method for the chip packaging structure shown in FIG. 2;
FIG. 18A to FIG. 18C are diagrams of a manufacturing process of a third part of steps in the manufacturing method shown in FIG. 14;
FIG. 19 is a schematic flowchart of a manufacturing method for the chip packaging structure shown in FIG. 5; and
FIG. 20A to FIG. 20C are diagrams of a manufacturing process of a part of steps in the manufacturing method shown in FIG. 19.

Reference numerals: 1: chip packaging structure; 10: first carrier board; 11: dielectric structure; 12: first conductive portion; 13: second conductive portion; 20: first chip; 31: first dielectric layer; 311: conductor; 312: groove; 32: third dielectric layer; 34: fourth dielectric layer; 35: bonding layer; 40: second carrier board; 41: dielectric structure; 42: first conductive portion; 421: metal layer; 422: connection portion; 43: via; 44: second conductive portion; 51: second thermal conductor; 511: first sub-thermal conductor; 512: second sub-thermal conductor; 52: connection layer; 53: first thermal conductor; 60: second chip; 61: substrate; 62: wafer; 63: second solder ball; 64: second dielectric layer; 71: capacitor; 72: first solder ball; 73: base plate; 80: third carrier board; 81: dielectric structure; 82: conductive structure; 821: first conductive portion; 8211: metal layer; 8212: connection portion; 822: second conductive portion; 823: communication portion; 90: third thermal conductor.

### DESCRIPTION OF EMBODIMENTS

The following clearly and completely describes the technical solutions in embodiments of this application with reference to the accompanying drawings in embodiments of this application. It is clear that the described embodiments are some but not all of embodiments of this application. All other embodiments obtained by a person of ordinary skill in the art based on embodiments of this application without creative efforts shall fall within the protection scope of this application.

The term "and/or" in this specification describes only an association relationship between associated objects and indicates that three relationships may exist. For example, A and/or B may indicate the following three cases: Only A exists, both A and B exist, and only B exists, where A and B may be singular or plural. The character "/" usually indicates an "or" relationship between the associated objects. "At least one (item)" means one or more, and "a plurality of" means two or more. "At least one of the following items (pieces)" or a similar expression thereof means any combination of these items, including a single item (piece) or any combination of a plurality of items (pieces). For example, at least one item (piece) of a, b, or c may indicate a, b, c, "a and b", "a and c", "b and c", or "a, b, and c", where a, b, and c may be singular or plural.

In the specification and claims of embodiments of this application, the terms such as "first" and "second" are intended to distinguish between different objects but do not indicate a particular order of the objects. For example, a first target object, a second target object, and the like are used for distinguishing between different target objects, but are not used for describing a specific order of the target objects.

Words similar to "connect", "connected", and the like are used to express interworking or mutual interaction between different components, and may include a direct connection or an indirect connection through another component. In addition, the terms "include", "have", and any variant thereof are intended to cover non-exclusive inclusion, for example, include a series of steps or units. A method, system, product, or device is not necessarily limited to those steps or units expressly listed, but may include other steps or units not expressly listed or inherent to such a process, method, product, or device. "On", "below", "left", "right", and the like are used only relative to an orientation of components in the accompanying drawings. These directional terms are relative concepts, are used for relative descriptions and clarifications, and may change accordingly as orientations in which the components in the accompanying drawings are placed change.

In addition, in embodiments of this application, the terms such as "example" or "for example" indicate giving an example, an illustration, or a description. Any embodiment or design scheme described as an "example" or "for example" in embodiments of this application should not be explained as being more preferred or more advantageous than another embodiment or design scheme. Exactly, use of the terms such as "example" or "for example" is intended to present a related concept in a specific manner.

In descriptions of embodiments of this application, unless otherwise stated, "plurality of" means two or more than two. For example, a plurality of processing units mean two or more processing units, and a plurality of systems mean two or more systems.

An electronic device such as a mobile phone, a watch, or a tablet usually includes a circuit board and a chip packaging structure, and the chip packaging structure is electrically connected to the circuit board. The chip packaging structure includes at least two chips. Herein, an example in which the chip packaging structure includes two chips is used for description. The two chips may be an SoC and a DDR SDRAM. The SoC and the DDR SDRAM may be packaged through FOPoP when the chip packaging structure is manufactured. Therefore, the SoC and DDR SDRAM are stacked. A film layer and an adhesive layer are disposed between the SoC and the DDR SDRAM, and thermal conductivity of the film layer and thermal conductivity of the adhesive layer are both poor. As a result, it is difficult for the DDR SDRAM to dissipate heat, leading to thermal throttling of the DDR SDRAM.

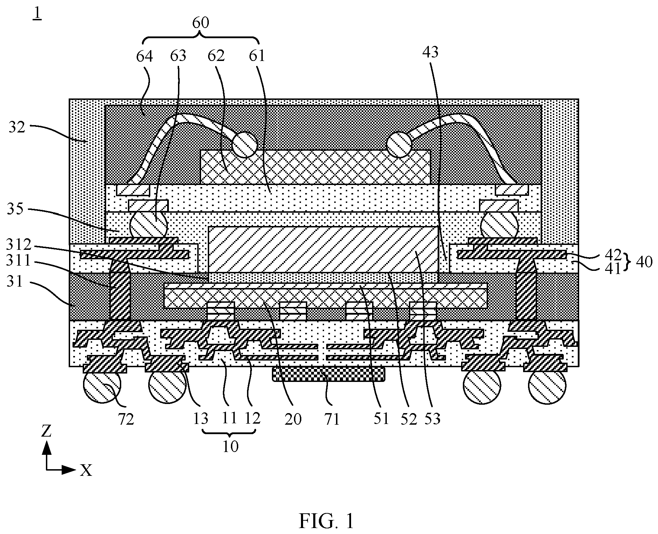

In view of this, as shown in FIG. 1, an embodiment of this application provides a chip packaging structure 1, including: a first carrier board 10, a first chip 20, a first dielectric layer 31, a second chip 60, a first thermal conductor 53, a second thermal conductor 51, a connection layer 52, a second carrier board 40, and a third dielectric layer 32.

The first carrier board 10 may be a metal redistribution layer (redistribution layer, RDL). As shown in FIG. 1, the first carrier board 10 is located at a position that is on the chip packaging structure 1 and that is near the bottom, and the first carrier board 10 includes a dielectric structure 11, a first conductive portion 12, and a second conductive portion 13. A part of the first conductive portion 12 is located in the dielectric structure 11, and the remaining part extends out of the bottom of the dielectric structure 11 and is connected to a capacitor 71 disposed at the bottom of the first carrier board 10. A top surface of the first conductive portion 12 is flush with a top surface of the dielectric structure 11. In other words, the top surface of the first conductive portion 12 is exposed from the dielectric structure 11.

It may be understood that, in this embodiment of this application, both a "top surface" and a "bottom surface" are surfaces determined with reference to a first solder ball 72 as the bottom of the chip packaging structure 1. For any component, a surface facing the first solder ball 72 is a bottom surface, and a surface facing away from the first solder ball 72 is a top surface.

As shown in FIG. 1, a part of the second conductive portion 13 is located in the dielectric structure 11, and the remaining part extends out of a bottom surface of the first carrier board 10 and is connected to the first solder ball 72 disposed on the bottom surface of the first carrier board 10. A top surface of the second conductive portion 13 is flush with the top surface of the dielectric structure 11. In other words, the top surface of the second conductive portion 13 is exposed from the dielectric structure 11.

As shown in FIG. 1, two first conductive portions 12 are located between two second conductive portions 13. In addition, the two first conductive portions 12 are electrically isolated from each other, the two second conductive portions 13 are electrically isolated from each other, and the first conductive portion 12 is also electrically isolated from the second conductive portion 13.

As shown in FIG. 1, the first chip 20 is disposed on the first carrier board 10. The first chip 20 may be an unpackaged chip, namely, a die. For example, in this embodiment, the first chip 20 may be an SoC. The SoC may be a target-specific integrated circuit, includes a complete structure for implementing one or more functions, and is embedded with software. In another embodiment, the first chip 20 may alternatively be a packaged chip. The first chip 20 may be soldered onto the first carrier board 10 by using a flip-chip technique. A pad on the first chip 20 may be connected to a pad on the first conductive portion 12 of the first carrier board 10 through a solder ball, thereby implementing an electrical connection between the first chip 20 and the first carrier board 10.

After the first chip 20 is soldered onto the first carrier board 10, the first chip 20 may be molded, to obtain the first dielectric layer 31 shown in FIG. 1. A bottom surface of the first chip 20 is higher than a bottom surface of the first dielectric layer 31, and a top surface of the first chip 20 is lower than a top surface of the first dielectric layer 31.

As shown in FIG. 1, the chip packaging structure 1 further includes a conductor 311 disposed at a same layer as the first dielectric layer 31. The conductor 311 may be a through interposer via (through interposer via, TIV). A thickness of the conductor 311 may be the same as a thickness of the first dielectric layer 31. In other words, a bottom surface of the conductor 311 is flush with the bottom surface of the first dielectric layer 31, and a top surface of the conductor 311 is flush with the top surface of the first dielectric layer 31. The bottom surface of the conductor 311 is connected to the second conductive portion 13 of the first carrier board 10. A material of the conductor 311 may include copper, nickel, silver, tin, or the like.

As shown in FIG. 1, the second carrier board 40 is disposed on a side that is of the first dielectric layer 31 and that faces away from the first carrier board 10. In other words, the first dielectric layer 31 is stacked between the first carrier board 10 and the second carrier board 40. The second carrier board 40 includes a dielectric structure 41 and a first conductive portion 42. A part of the first conductive portion 42 is located in the dielectric structure 41, and the remaining part of the first conductive portion 42 extends out of a top surface of the dielectric structure 41. A bottom surface of the first conductive portion 42 is flush with a bottom surface of the dielectric structure 41, and is connected to the conductor 311. In this way, the first conductive portion 42 may be electrically connected to the second conductive portion 13 of the first carrier board 10 and the first solder ball 72 through the conductor 311.

In this embodiment, the second chip 60 may be a packaged chip, for example, a DRR SDRAM. The second chip 60 may be disposed on a side that is of the second carrier board 40 and that faces away from the first carrier board 10. The second chip 60 includes a substrate 61, a wafer 62, a second solder ball 63, and a second dielectric layer 64. The substrate 61 is soldered onto the first conductive portion 42 of the second carrier board 40 through the second solder ball 63. In this way, the second chip 60 may be connected to the second conductive portion 13 of the first carrier board 10 through the second solder ball 63, the first conductive portion 42 of the second carrier board 40, and the conductor 311. The wafer 62 is fastened to a top surface of the substrate 61, and a top surface of the wafer 62 is electrically connected to the top surface of the substrate 61. A bottom surface of the substrate 61 is flush with a bottom surface of the second dielectric layer 64, and a top surface of the second dielectric layer 64 is higher than the top surface of the wafer 62.

As shown in FIG. 1, the second thermal conductor 51 covers a surface that is of the first chip 20 and that faces the second chip 60, that is, the second thermal conductor 51 covers the top surface of the first chip 20. For example, the second thermal conductor 51 is in contact with the top surface of the first chip 20. In an application process of the chip packaging structure 1, the first chip 20 generates heat. When the second thermal conductor 51 covers the top surface of the first chip 20, the first chip 20 may conduct the generated heat to the second thermal conductor 51, and dissipate the heat in an X direction and a Y direction (not shown in FIG. 1) through the second thermal conductor 51, so that heat dissipation effect of the chip packaging structure 1 can be improved, thereby reducing thermal resistance, and avoiding thermal throttling of the first chip 20. The Y direction is a direction perpendicular to both the X direction and a Z direction shown in FIG. 1.

As shown in FIG. 1, the second thermal conductor 51 may be located below the second carrier board 40, that is, a top surface of the second thermal conductor 51 may be lower than a bottom surface of the second carrier board 40. To reserve avoiding space for the second thermal conductor 51, a via 43 is provided in a middle of the second carrier board 40. A size of the via 43 in the X direction may be less than a size of the first chip 20 in the X direction. To increase a heat dissipation area of the second thermal conductor 51 to improve heat dissipation effect, a size of the second thermal conductor 51 in the X direction may be the same as the size of the first chip 20 in the X direction. That is, the size of the second thermal conductor 51 in the X direction is greater than the size of the via 43 in the X direction.

In this embodiment, a material of the second thermal conductor 51 may include metal or silicon. When the material of the second thermal conductor 51 includes metal, the material of the second thermal conductor 51 may specifically include copper, aluminum, or the like. The metal features good thermal conductivity. Therefore, when the material of the second thermal conductor 51 includes the metal, the second thermal conductor 51 can better dissipate heat.

As shown in FIG. 1, the connection layer 52 covers the second thermal conductor 51, and a size of the connection layer 52 in the X direction may be the same as a size of the first thermal conductor 53 in the X direction. A bottom surface of the connecting layer 52 is lower than the bottom surface of the second carrier board 40, and a top surface of the connecting layer 52 may be flush with the bottom surface of the second carrier board 40 or higher than a top surface of the second carrier board 40.

In this embodiment, the connection layer 52 is a silver paste layer or a solder layer. Because a material of silver paste is silver, which belongs to metal, a material of the solder layer is usually tin, which also belongs to the metal, and the metal has good thermal conductivity. In another embodiment, the connection layer 52 may alternatively be a connection adhesive layer, for example, a die attach film (die attach film, DAF).

The second thermal conductor 51 is usually thin. To improve heat dissipation effect, the first thermal conductor 53 may be disposed between the connection layer 52 and the second chip 60, and a thickness of the first thermal conductor 53 is greater than a thickness of the second thermal conductor 51. In this way, after the first chip 20 conducts heat to the second thermal conductor 51, the second thermal conductor 51 can better conduct the heat to the first thermal conductor 53 through the connection layer 52, so that the second thermal conductor 51, the connection layer 52, and the first thermal conductor 53 jointly dissipate the heat. Because the first thermal conductor 53 is located above the first chip 20, the first thermal conductor 53 may assist the first chip 20 in heat dissipation in the Z direction, thereby further improving heat dissipation effect.

It may be understood that, in this embodiment of this application, both "above" and "below" are orientations determined with reference to the first solder ball 72 as the bottom of the chip packaging structure 1.

In addition, when the connection layer 52 located between the second thermal conductor 51 and the first thermal conductor 53 is the silver paste layer or the solder layer, heat can be better conducted between the second thermal conductor 51 and the first thermal conductor 53, thereby further improving heat dissipation effect of the chip packaging structure 1.

Further, a surface that is of the first thermal conductor 53 and that faces the first carrier board 10 is lower than a surface that is of the second carrier board 40 and that faces the first carrier board 10, and a surface that is of the first thermal conductor 53 and that faces away from the first carrier board 10 is higher than a surface that is of the second carrier board 40 and that faces away from the first carrier board 10. In other words, a bottom surface of the first thermal conductor 53 is lower than the bottom surface of the second carrier board 40, and a top surface of the first thermal conductor 53 is higher than the top surface of the second carrier board 40, that is, the thickness of the first thermal conductor 53 is greater than a thickness of the second carrier board 40. A larger thickness of the first thermal conductor 53 indicates a larger heat dissipation area of the first thermal conductor 53. In this way, heat dissipation effect of the first thermal conductor 53 can be improved. In addition, the top surface of the first thermal conductor 53 is lower than the bottom surface of the substrate 61 of the second chip 60, thereby avoiding a case in which the second solder ball 63 of the second chip 60 cannot be in contact with and connected to the first conductive portion 42 of the second carrier board 40 because the top surface of the first thermal conductor 53 is too high.

A gap exists between two sides of the first thermal conductor 53 and a side wall of the via 43. In this way, the via 43 provided on the second carrier board 40 can provide avoiding space for the first thermal conductor 53, thereby facilitating disposing of the first thermal conductor 53 between the first chip 20 and the second chip 60.

A material of the first thermal conductor 53 includes metal or silicon. When the first thermal conductor 53 includes metal, the metal may be specifically copper, aluminum, or the like. Because the metal has good thermal conductivity, when the material of the first thermal conductor 53 includes the metal, thermal conduction and heat dissipation can be better implemented, thereby further improving heat dissipation effect of the chip packaging structure 1.

To improve firmness of a connection between the first chip 20, the second carrier board 40, the second thermal conductor 51, the connection layer 52, and the first thermal conductor 53, and the first chip 20, in this embodiment, as shown in FIG. 1, the chip packaging structure 1 further includes a bonding layer 35. A part of the bonding layer 35 is located between the second chip 60 and the second carrier board 40, a part of the bonding layer 35 is located in a gap between the first thermal conductor 53 and the second carrier board 40, and a part of the bonding layer 35 is further located in a gap between the second chip 60 and the first thermal conductor 53. When the chip packaging structure 1 is used, the second chip 60 generates heat, and the bonding layer 35 is located on a side that is of the second chip 60 and that faces the second carrier board 40. Therefore, the second chip 60 conducts the generated heat to the bonding layer 35. Because the first thermal conductor 53 is located between the first chip 20 and the second chip 60, and the part of bonding layer 35 is located in the gap between the second chip 60 and the first thermal conductor 53, the bonding layer 35 may conduct, to the first thermal conductor 53, the heat conducted by the second chip 60, and the first thermal conductor 53 dissipates the heat. Therefore, the second chip 60 may conduct the generated heat to the first thermal conductor 53 through the bonding layer 35, to dissipate the heat in the X direction and the Y direction (not shown in FIG. 1) of the first thermal conductor 53, so that heat dissipation effect of the chip packaging structure 1 can be improved, thereby reducing thermal resistance, and avoiding thermal throttling of the second chip 60.

After the first chip 20 is fastened to the second carrier board 40, molding processing may be performed on the first chip 20, to form the third dielectric layer 32. In other words, the third dielectric layer 32 may be disposed on the top surface of the second carrier board 40, and wrap the first chip 20 and the bonding layer 35.

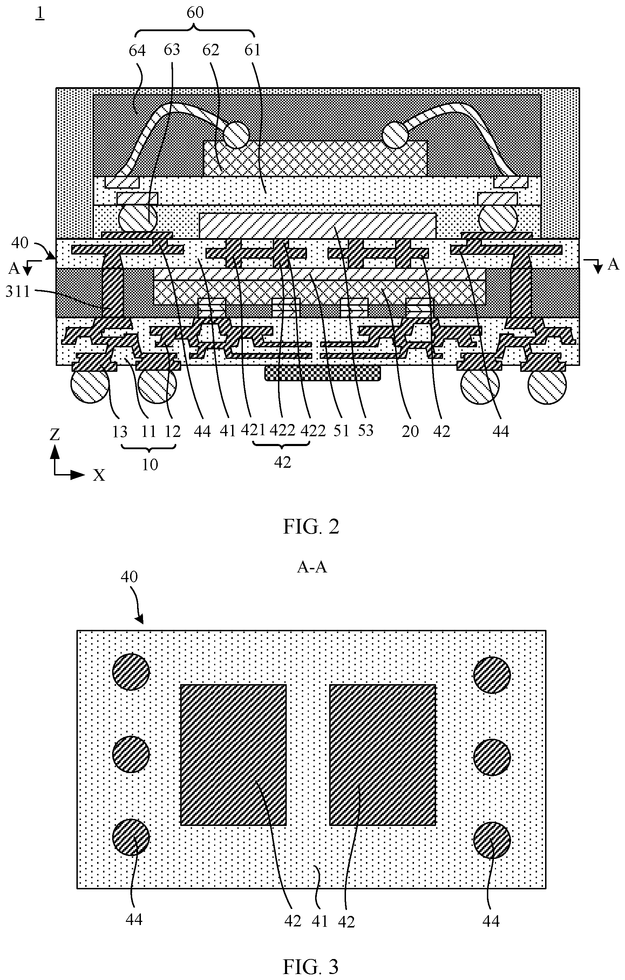

In another embodiment of this application, a difference from the embodiment shown in FIG. 1 lies in a structure of the second carrier board 40 and removal of the connection layer 52 in this embodiment on a basis of the embodiment shown in FIG. 1. For example, in this embodiment, as shown in FIG. 2, the second carrier board 40 includes a dielectric structure 41, a first conductive portion 42, and a second conductive portion 44. The second thermal conductor 51 is connected to the first thermal conductor 53 through the first conductive portion 42.

Specifically, as shown in FIG. 3, the second carrier board 40 may include two second conductive portions 44 that are disposed opposite to each other and have a spacing, and the two second conductive portions 44 are electrically isolated from each other. As shown in FIG. 2, a part of the second conductive portion 44 is disposed in the dielectric structure 41, and the remaining part extends out of a top surface of the dielectric structure 41 and is connected to the second solder ball 63 of the second chip 60. A bottom surface of the second conductive portion 44 is flush with a bottom surface of the dielectric structure 41. In other words, the bottom surface of the second conductive portion 44 is exposed from the bottom surface of the dielectric structure 41, and is connected to the conductor 311. Therefore, the second chip 60 may be electrically connected to the second conductive portion 13 in the first carrier board 10 through the second conductive portion 44 and the conductor 311.

As shown in FIG. 2, the first conductive portion 42 is located between the two second conductive portions 44, and the first conductive portion 42 may be electrically isolated from the second conductive portion 44. A top surface of the first conductive portion 42 is flush with the top surface of the dielectric structure 41, and the top surface of the first conductive portion 42 is connected to the bottom surface of the first thermal conductor 53. A bottom surface of the first conductive portion 42 is also flush with the bottom surface of the dielectric structure 41, and the bottom surface of the first conductive portion 42 is connected to the top surface of the second thermal conductor 51. That is, the first conductive portion 42 is connected between the second thermal conductor 51 and the first thermal conductor 53. Because a material of the first conductive portion 42 may be metal, and the metal has high thermal conductivity, after the first chip 20 conducts generated heat to the second thermal conductor 51, the second thermal conductor 51 may conduct the heat to the first thermal conductor 53 through the first conductive portion 42, so that the second thermal conductor 51, the first conductive portion 42, and the first thermal conductor 53 jointly dissipate the heat, thereby further improving heat dissipation effect. Therefore, the second carrier board 40 can implement a connection between the second chip 60 and the first carrier board 10, and can also implement heat conduction between the second thermal conductor 51 and the first thermal conductor 53.

As shown in FIG. 2, to implement electrical isolation between the first conductive portion 42 and the second conductive portion 44, a size of the first conductive portion 42 in the X direction is less than the size of the second thermal conductor 51 in the X direction. The size of the first thermal conductor 53 in the X direction may be the same as the size of the first conductive portion 42 in the X direction.

For the structure of the first conductive portion 42, in a possible implementation, as shown in FIG. 2, the first conductive portion 42 includes a metal layer 421 and a connection portion 422, a thickness of the metal layer 421 is less than the thickness of the second carrier board 40, and the metal layer 421 is separately connected to the first thermal conductor 53 and the second thermal conductor 51 through the connection portion 422. For example, the metal layer 421 is located in a middle of the second carrier board 40 in the Z direction, there may be a plurality of connection portions 422, a part of the plurality of connection portions 422 are located between the metal layer 421 and the second thermal conductor 51, and the other part of the plurality of connection portions 422 are located between the metal layer 421 and the first thermal conductor 53. Therefore, heat conduction between the second thermal conductor 51 and the first thermal conductor 53 can be implemented.

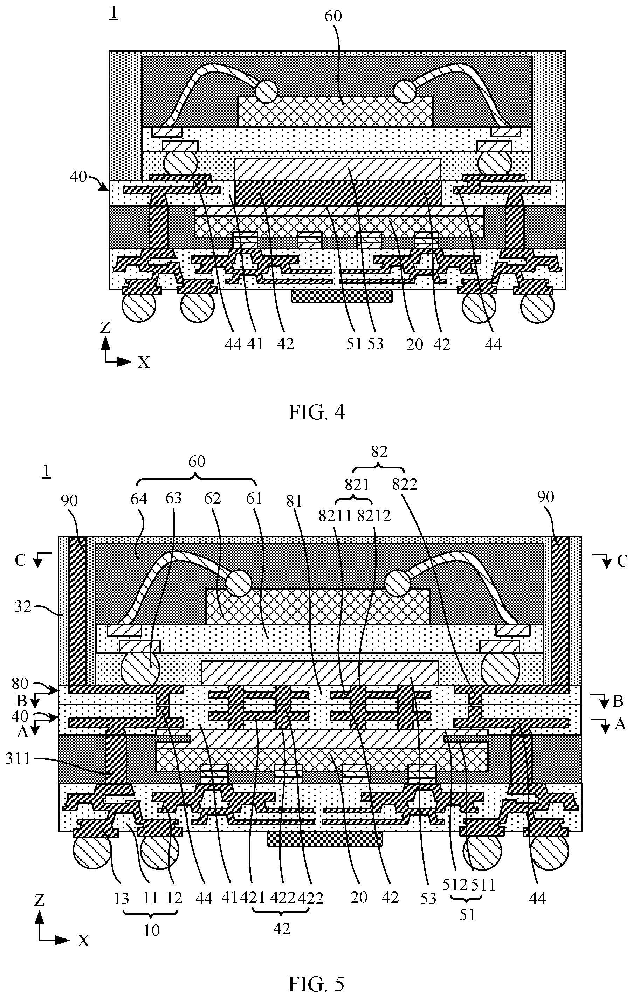

In another possible implementation, as shown in FIG. 4, the first conductive portion 42 includes a metal block, and a thickness of the metal block is the same as the thickness of the second carrier board 40. For example, a structure of the metal block may be a cube structure. A size of a surface that is of the metal block and that faces the second thermal conductor 51 and a size of a surface that is of the metal block and that faces the first thermal conductor 53 are the same as a size of a surface that is of the first thermal conductor 53 and that faces the second carrier board 40, that is, a size of a bottom surface of the metal block and a size of a top surface of the metal block are the same as a size of the bottom surface of the first thermal conductor 53. That is, both a size of the bottom surface of the first conductive portion 42 and a size of the top surface of the first conductive portion 42 are the same as the size of the bottom surface of the first conductive portion 42. Because the first conductive portion 42 can achieve thermal conduction effect, a thermal conduction area of the first conductive portion 42 can be increased by using the structure, thereby increasing thermal conduction effect of the first conductive portion 42. In addition, a contact area between the first conductive portion 42 and the first thermal conductor 53 is larger, and a contact area between the first conductive portion 42 and the second thermal conductor 51 is larger. Therefore, the first conductive portion 42 can also quickly conduct, to the first thermal conductor 53, heat conducted by the second thermal conductor 51, thereby facilitating quick heat dissipation.

In another embodiment of this application, as shown in FIG. 5, a difference from the embodiment shown in FIG. 2 lies in a second thermal conductor 51 and that the chip packaging structure 1 further includes a third thermal conductor 90 and a third carrier board 80 on a basis of the embodiment shown in FIG. 2.

As shown in FIG. 5, the second thermal conductor 51 includes a first sub-thermal conductor 511 and a second sub-thermal conductor 512. The first sub-thermal conductor 511 is connected to the first chip 20, and the second sub-thermal conductor 512 is connected between the first sub-thermal conductor 511 and the first conductive portion 42. A top surface of the second sub-thermal conductor 512 is higher than the bottom surface of the dielectric structure 41 of the second carrier board 40.

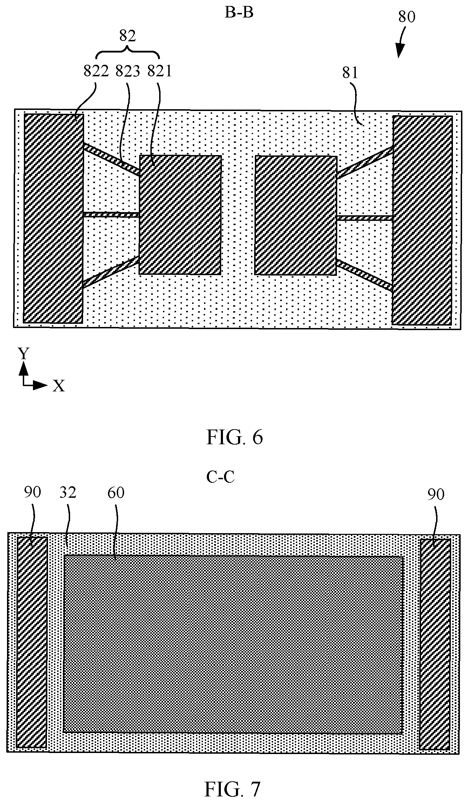

As shown in FIG. 5, the third carrier board 80 may be an RDL. The third carrier board 80 is stacked between the second carrier board 40 and the first thermal conductor 53. The third carrier board 80 includes a dielectric structure 81 and a conductive structure 82. As shown in FIG. 6, the conductive structure 82 includes a first conductive portion 821, a plurality of second conductive portions 822, and a communication portion 823. There may be one or more first conductive portions 821. For example, in FIG. 6, there are two first conductive portions 821, and the two first conductive portions 821 are arranged in the X direction and have a spacing. In addition, as shown in FIG. 5, in this embodiment, the two first conductive portions 821 respectively correspond in position to and are connected to two first conductive portions 42 of the second carrier board 40, and top surfaces of the two first conductive portions 821 are further connected to the first thermal conductor 53. That is, the two first conductive portions 821 are connected between the first conductive portions 42 of the second carrier board 40 and the first thermal conductor 53.

As shown in FIG. 6, the plurality of second conductive portions 822 are arranged in the X direction and have a spacing. For example, in this embodiment, there are two second conductive portions 822, and the two second conductive portions 822 are arranged in the X direction and have a spacing. The first conductive portion 821 is located between the two second conductive portions 822, and each second conductive portion 822 is connected to the first conductive portion 821 through the communication portion 823. It may be understood that, in the third carrier board 80, the first conductive portion 821, the second conductive portion 822, and the communication portion 823 are manufactured by using a same technique. Therefore, materials of the three parts may be the same, for example, all are metal. In addition, as shown in FIG. 5, the first conductive portion 821 includes a metal layer 8211 and a connection portion 8212. A thickness of the metal layer 8211 is less than a thickness of the third carrier board 80, and the metal layer 8211 is connected to the first thermal conductor 53 and the first conductive portion 42 of the second carrier board 40 through the connection portion 8212. For example, the metal layer 8211 is located in a middle of the third carrier board 80 in the Z direction, there may be a plurality of connection portions 8212, a part of the plurality of connection portions 8212 are located between the metal layer 8211 and the second carrier board 40, and the other part of the plurality of connection portions 8212 are located between the metal layer 8211 and the first thermal conductor 53. Therefore, heat of the second thermal conductor 51 conducted through the second carrier board 40 can be conducted to the first thermal conductor 53 through the metal layer 8211.

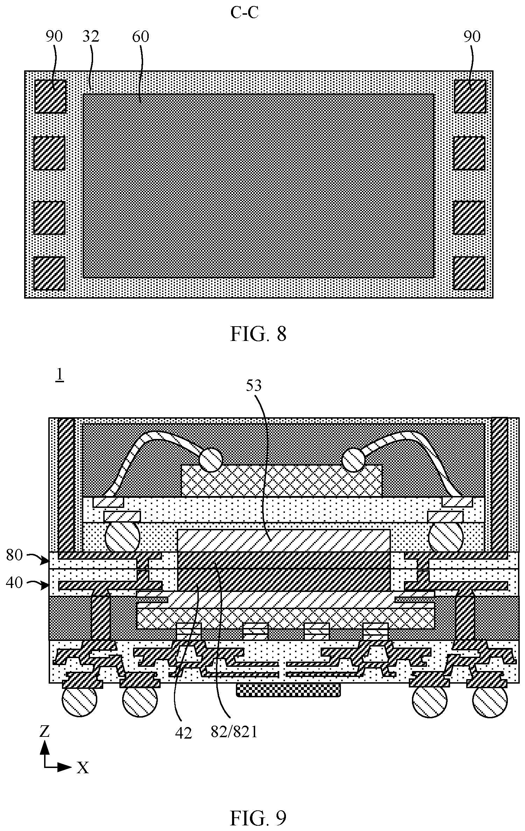

In another embodiment, there may be one first conductive portion 821. For example, as shown in FIG. 9, the first conductive portion 821 includes a metal block, and a thickness of the metal block of the conductive structure 82 is the same as the thickness of the third carrier board 80. Because the first conductive portion 821 can achieve thermal conduction effect, a thermal conduction area of the first conductive portion 821 can be increased by using the structure, thereby increasing thermal conduction effect of the first conductive portion 821. In addition, a contact area between the first conductive portion 821 and the first thermal conductor 53 is larger. This can also increase thermal conduction effect of the first conductive portion 821.

It may be understood that, in the embodiments shown in FIG. 5 and FIG. 9, the structure of the first conductive portion 42 of the second carrier board 40 is the same as a structure of the first conductive portion 821 of the third carrier board 80. In another embodiment, the structure of the first conductive portion 42 of the second carrier board 40 may be different from a structure of the first conductive portion 821 of the third carrier board 80. For example, the first conductive portion 42 of the second carrier board 40 uses the structure shown in FIG. 5, and the first conductive portion 821 of the third carrier board 80 uses the structure shown in FIG. 9; or the first conductive portion 42 of the second carrier board 40 uses the structure shown in FIG. 9, and the first conductive portion 821 of the third carrier board 80 uses the structure shown in FIG. 5.

As shown in FIG. 5, the third thermal conductor 90 is located on a side that is of the third carrier board 80 and that faces away from the second carrier board 40. For example, the third thermal conductor 90 is disposed on the second conductive portion 822 of the third carrier board 80. Specifically, the third thermal conductor 90 is in contact with the second conductive portion 822 of the third carrier board 80. In addition, a top surface of the third thermal conductor 90 may be flush with or slightly lower than a top surface of the third dielectric layer 32. In this way, the first chip 20 may conduct generated heat to the first thermal conductor 53 sequentially through the second thermal conductor 51, the first conductive portion 42 of the second carrier board 40, and the first conductive portion 821 of the third carrier board 80. In addition, the first chip 20 may further conduct the generated heat to the third thermal conductor 90 sequentially through the second thermal conductor 51, the first conductive portion 42 of the second carrier board 40, the first conductive portion 821 of the third carrier board 80, the communication portion 823 shown in FIG. 6, and the second conductive portion 822 of the third carrier board 80. In this way, the second thermal conductor 51, the first conductive portion 42 of the second carrier board 40, the conductive structure 82 of the third carrier board 80, the first thermal conductor 53, and the third thermal conductor 90 jointly dissipate the heat, thereby further improving heat dissipation effect.

For example, as shown in FIG. 7, there may be two third thermal conductors 90, and the two third thermal conductors 90 are respectively located on two sides of the second chip 60. In another example, as shown in FIG. 8, there may be four, six, or more third thermal conductors 90, a part of the third thermal conductors 90 are located on one side of the second chip 60, and the other part of the third thermal conductors 90 are located on the other side of the second chip 60.

A material of the third thermal conductor 90 includes metal or silicon. For example, the material of the third thermal conductor 90 includes metal, for example, copper or aluminum. Because the metal has good thermal conductivity, when the material of the third thermal conductor 90 includes the metal, thermal conduction and heat dissipation can be better implemented, thereby further improving heat dissipation effect of the chip packaging structure 1.

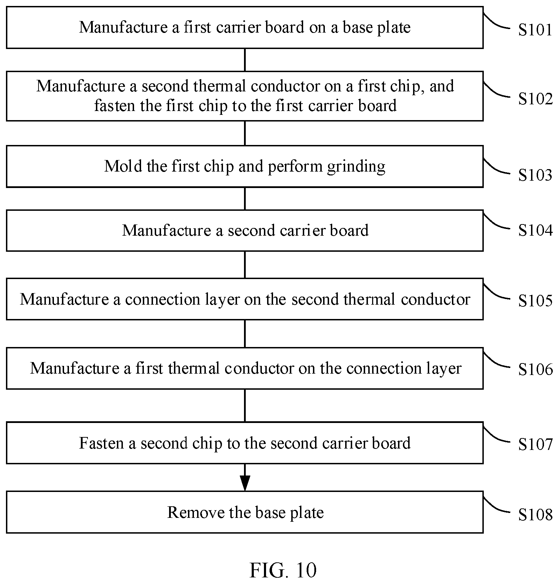

An embodiment of this application further provides a manufacturing method for a chip packaging structure 1, which may be applied to the chip packaging structure 1 shown in FIG. 1. As shown in FIG. 10, the manufacturing method includes the following steps.

S101: Manufacture a first carrier board on a base plate.

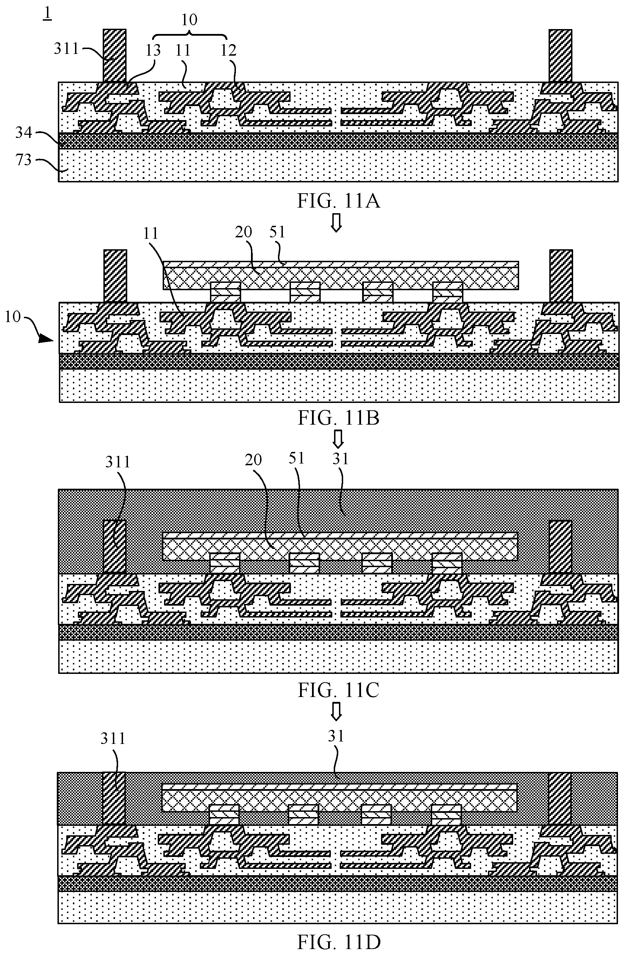

As shown in FIG. 11A, a top surface of the base plate 73 is covered with a fourth dielectric layer 34. The first carrier board 10 may be manufactured on the fourth dielectric layer 34. The first carrier board 10 includes a dielectric structure 11, a first conductive portion 12, and a second conductive portion 13. Then, a conductor 311 is manufactured on the second conductive portion 13 of the first carrier board 10. The conductor 311 may be a TIV.

S102: Manufacture a second thermal conductor on a first chip, and fasten the first chip to the first carrier board.

In this embodiment, the second thermal conductor 51 may be first manufactured on the first chip 20, and then, as shown in FIG. 11B, the first chip 20 fastened with the second thermal conductor 51 is fastened to the first carrier board 10. Specifically, the first chip 20 fastened with the second thermal conductor 51 may be fastened to the first conductive portion 12 of the first carrier board 10 through flip-chip (flip-chip, FC) soldering. In another embodiment, the first chip 20 may alternatively be first fastened to the first carrier board 10, and then the second thermal conductor 51 is manufactured on the first chip 20.

S103: Mold the first chip and perform grinding.

As shown in FIG. 11C, a first dielectric layer 31 may be formed in a process of performing molding (molding, MD) on the first chip 20. The first dielectric layer 31 may wrap the first chip 20, the second thermal conductor 51, and the conductor 311, a top surface of the first dielectric layer 31 is higher than a top surface of the conductor 311, and the top surface of the first dielectric layer 31 is also higher than a top surface of the second thermal conductor 51.

As shown in FIG. 11D, after molding, grinding (backside grinding, BG) processing may be performed on the top surface of the first dielectric layer 31, to thin the first dielectric layer 31 and expose the conductor 311.

S104: Manufacture a second carrier board.

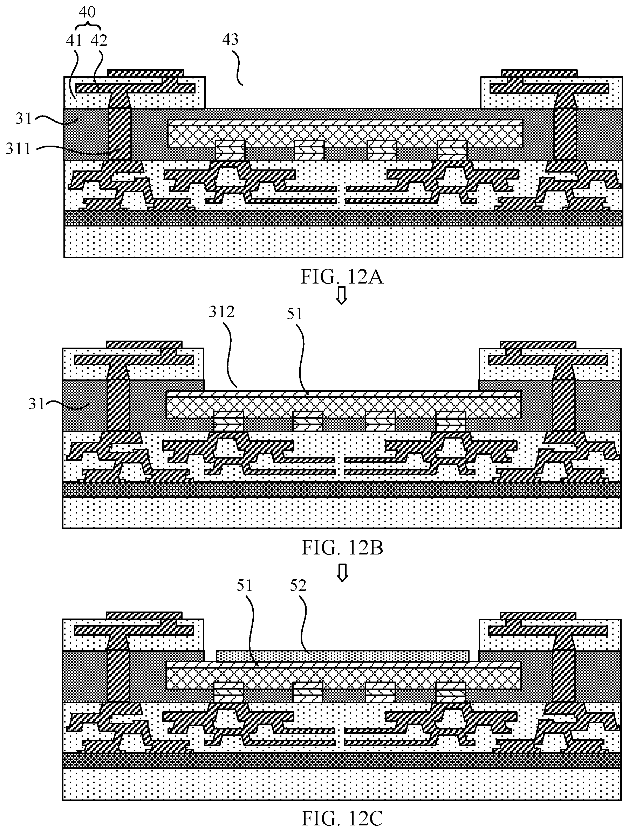

As shown in FIG. 12A, the second carrier board 40 may be manufactured on the first dielectric layer 31. A via 43 is provided on the second carrier board 40. The second carrier board 40 includes a dielectric structure 41 and a first conductive portion 42. The first conductive portion 42 is connected to the conductor 311. The second carrier board 40 may also be an RDL.

As shown in FIG. 12B, a groove 312 may be manufactured on the first dielectric layer 31 by using a laser grooving (cavity drill) technique, and a part of the top surface of the second thermal conductor 51 is exposed.

S105: Manufacture a connection layer on the second thermal conductor.

As shown in FIG. 12C, the connection layer 52 may be manufactured on the exposed part of the top surface of the second thermal conductor 51.

S106: Manufacture a first thermal conductor on the connection layer.

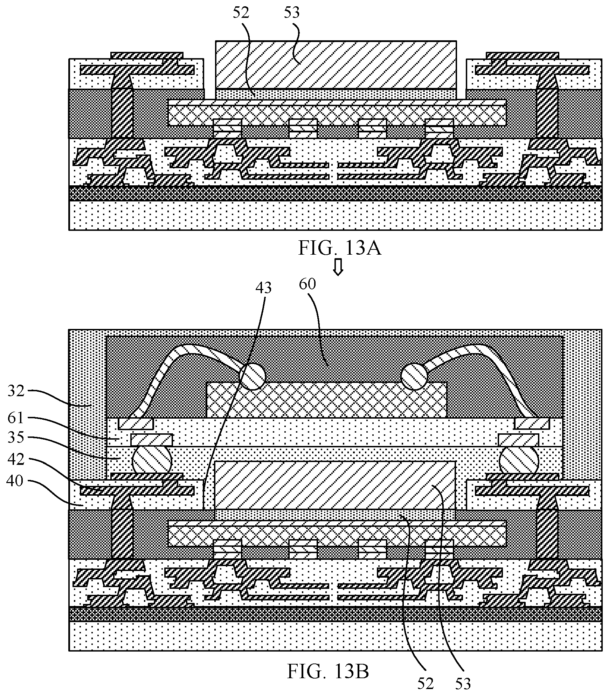

As shown in FIG. 13A, the first thermal conductor 53 may be attached to the connection layer 52.

S107: Fasten a second chip to the second carrier board.

As shown in FIG. 13B, the second chip 60 may be soldered onto the first conductive portion 42 of the second carrier board 40 by using a surface mounted technology (surface mounted technology, SMT) technique, and a bonding layer 35 is manufactured between the second chip 60 and the second carrier board 40 through underfill (underfill, UF). A part of the bonding layer 35 is located between a substrate 61 of the second chip 60 and the second carrier board 40, and a part of the bonding layer 35 is located in the via 43 of the second carrier board 40, and is located between the connection layer 52 and the second carrier board 40, and in a gap between the first thermal conductor 53 and the second carrier board 40.

As shown in FIG. 13B, the second chip 60 is molded, to form a third dielectric layer 32. The third dielectric layer 32 may wrap the second chip 60 and the bonding layer 35, and a top surface of the third dielectric layer 32 is higher than a top surface of the second chip 60.

S108: Remove the base plate.

The base plate 73 and the fourth dielectric layer 34 may be removed from the chip packaging structure 1 through debonding (debonding, DB). Then, a capacitor 71 is soldered to a bottom surface of the first conductive portion 12 of the first carrier board 10, and a first solder ball 72 is soldered to a bottom surface of the second conductive portion 13 of the first carrier board 10. The top surface of the third dielectric layer 32 is ground and thinned, to form the chip packaging structure 1 shown in FIG. 1.

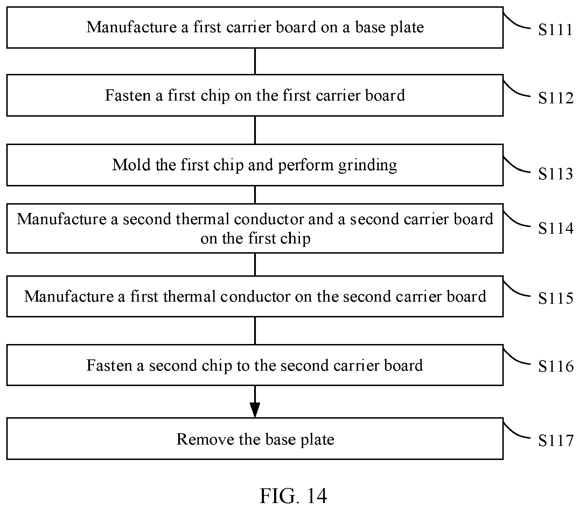

In another embodiment of this application, a manufacturing method for a chip packaging structure 1 is further provided. The manufacturing method is applied to the chip packaging structure 1 shown in FIG. 2. As shown in FIG. 14, the manufacturing method includes the following steps.

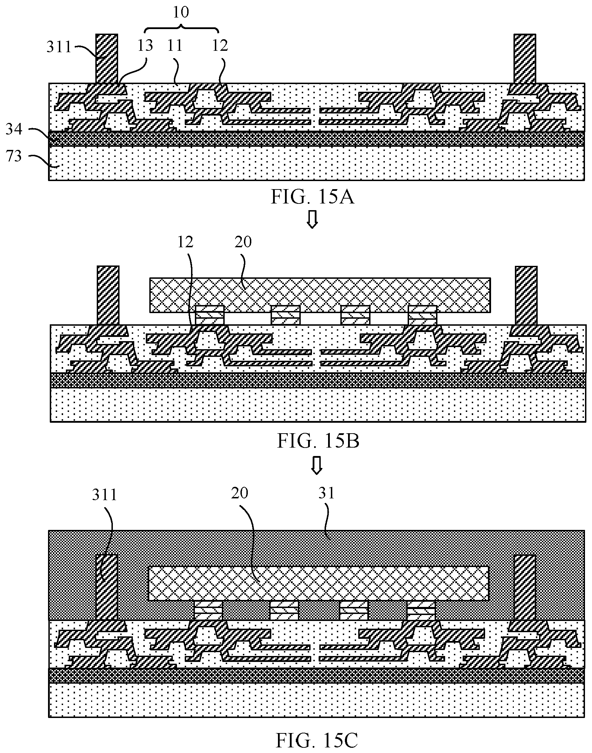

S111: As shown in FIG. 15A, manufacture a first carrier board on a base plate.

Refer to step S101 shown in FIG. 10.

S112: Fasten a first chip to the first carrier board.

As shown in FIG. 15B, the first chip 20 may be fastened to a first conductive portion 12 of the first carrier board 10 through FC.

S113: Mold the first chip and perform grinding.

As shown in FIG. 15C, a first dielectric layer 31 may be formed in a process of performing molding on the first chip 20. The first dielectric layer 31 may wrap the first chip 20 and a conductor 311, a top surface of the first dielectric layer 31 is higher than a top surface of the conductor 311, and the top surface of the first dielectric layer 31 is also higher than a top surface of the first chip 20.

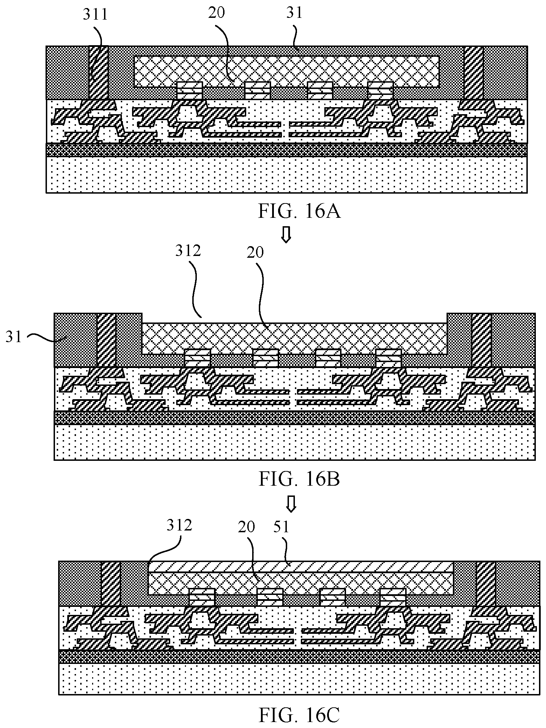

As shown in FIG. 16A, after molding, grinding processing may be performed on the top surface of the first dielectric layer 31, to thin the first dielectric layer 31 and expose the conductor 311. The top surface of the first chip 20 is lower than the top surface of the first dielectric layer 31.

S114: Manufacture a second thermal conductor and a second carrier board on the first chip.

As shown in FIG. 16B, a groove 312 may be first manufactured on the first dielectric layer 31, to expose a part of the top surface of the first chip 20. Then, as shown in FIG. 16C, the second thermal conductor 51 is manufactured on the first chip 20 in the groove 312. A top surface of the second thermal conductor 51 is flush with the top surface of the first dielectric layer 31.

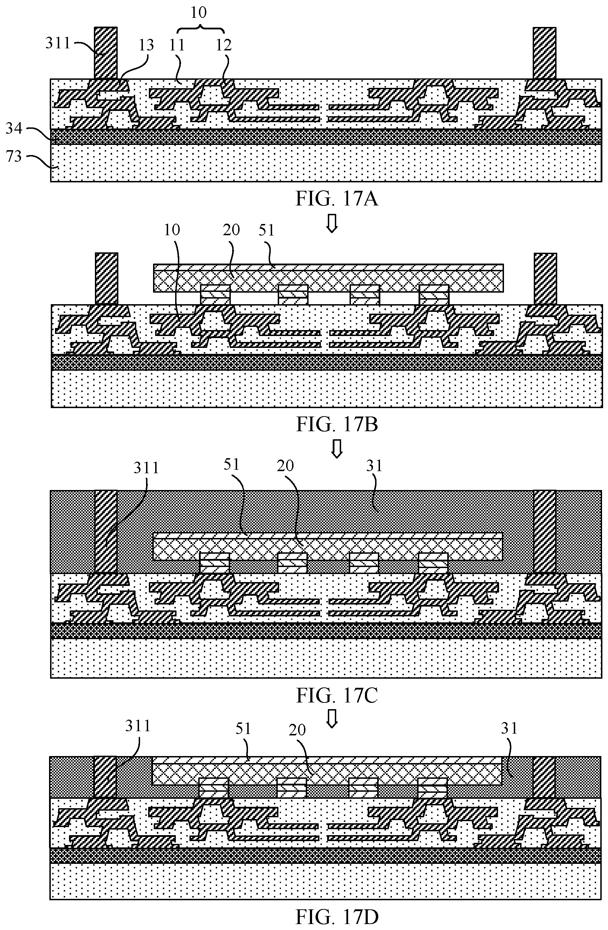

It may be understood that, in this embodiment, the first chip 20 is first fastened to the first carrier board 10, and then the second thermal conductor 51 is manufactured on the first chip 20. In another embodiment, the second thermal conductor 51 may be first manufactured on the first chip 20, and then the first chip 20 fastened with the second thermal conductor 51 is fastened to the first carrier board 10. For example, as shown in FIG. 17A, the first carrier board 10 and the conductor 311 are manufactured on the base plate 73. As shown in FIG. 17B, the second thermal conductor 51 is manufactured on the first chip 20, and then the first chip 20 fastened with the second thermal conductor 51 is soldered onto the first carrier board 10. As shown in FIG. 17C, the first chip 20 is molded, to form the first dielectric layer 31, and the first dielectric layer 31 wraps the first chip 20 and the conductor 311. The top surface of the first dielectric layer 31 may be flush with a top surface of the conductor 311, and is higher than the top surface of the second thermal conductor 51. As shown in FIG. 17D, the first dielectric layer 31 is ground, to expose the top surface of the second thermal conductor 51.

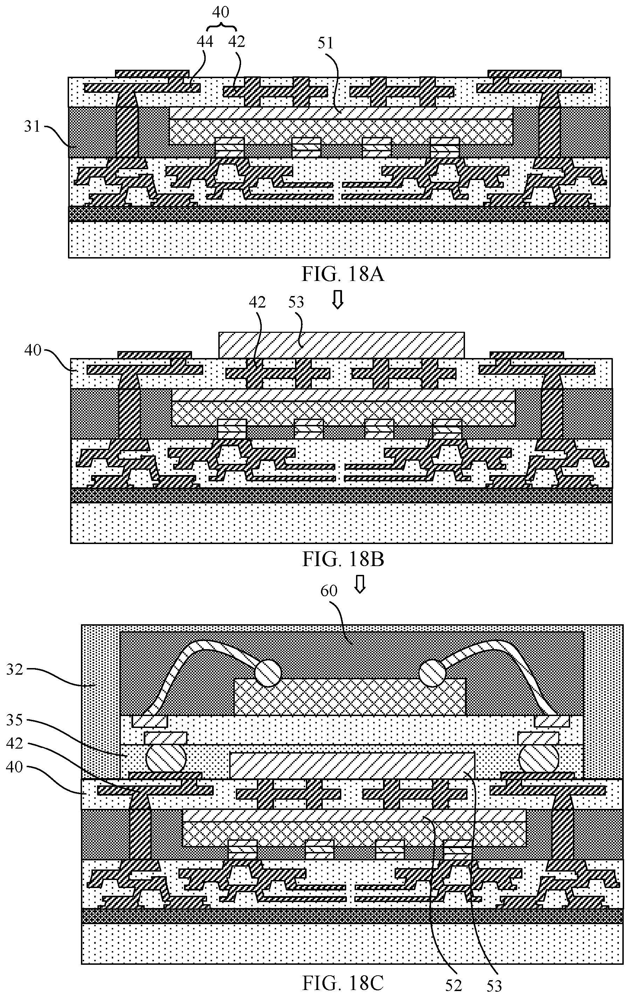

As shown in FIG. 18A, the second carrier board 40 is manufactured on the first dielectric layer 31 and the second thermal conductor 51. A first conductive portion 42 of the second carrier board 40 is connected to the second thermal conductor 51, and a second conductive portion 44 is connected to the conductor 311.

S115: Manufacture a first thermal conductor on the second carrier board.

As shown in FIG. 18B, a first thermal conductor 53 is manufactured on the second carrier board 40, and the first thermal conductor 53 is connected to the first conductive portion 42.

S116: Fasten a second chip to the second carrier board.

As shown in FIG. 18C, the second chip 60 may be soldered onto the first conductive portion 42 of the second carrier board 40 by using an SMT technique, and a bonding layer 35 is manufactured between the second chip 60 and the second carrier board 40 through underfill.

As shown in FIG. 18C, the second chip 60 is molded, to form a third dielectric layer 32. The third dielectric layer 32 may wrap the second chip 60 and the bonding layer 35, and a top surface of the third dielectric layer 32 is higher than a top surface of the second chip 60.

S117: Remove the base plate.

The base plate 73 and a fourth dielectric layer 34 may be removed from the chip packaging structure 1 through debonding. Then, a capacitor 71 is soldered to a bottom surface of the first conductive portion 12 of the first carrier board 10, and a first solder ball 72 is soldered to a bottom surface of a second conductive portion 13 of the first carrier board 10. The top surface of the third dielectric layer 32 is ground and thinned, to form the chip packaging structure 1 shown in FIG. 2.

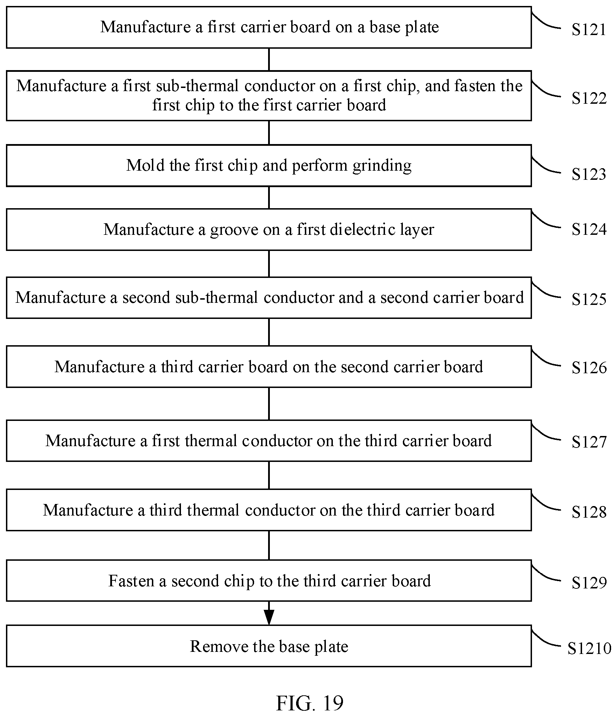

In another embodiment of this application, a manufacturing method for a chip packaging structure 1 is further provided. The manufacturing method is applied to the chip packaging structure 1 shown in FIG. 5. As shown in FIG. 19, the manufacturing method includes the following steps.

S121: As shown in FIG. 11A, manufacture a first carrier board on a base plate.

Refer to step S101 shown in FIG. 10.

S122: Manufacture a first sub-thermal conductor on a first chip, and fasten the first chip to the first carrier board.

Refer to step S102 shown in FIG. 10.

In another embodiment, the first chip 20 may alternatively be fastened to the first carrier board 10 first, and then the first sub-thermal conductor 511 is manufactured on the first chip 20.

S123: Mold the first chip and perform grinding.

Refer to step S103 shown in FIG. 10.

S124: Manufacture a groove on a first dielectric layer.

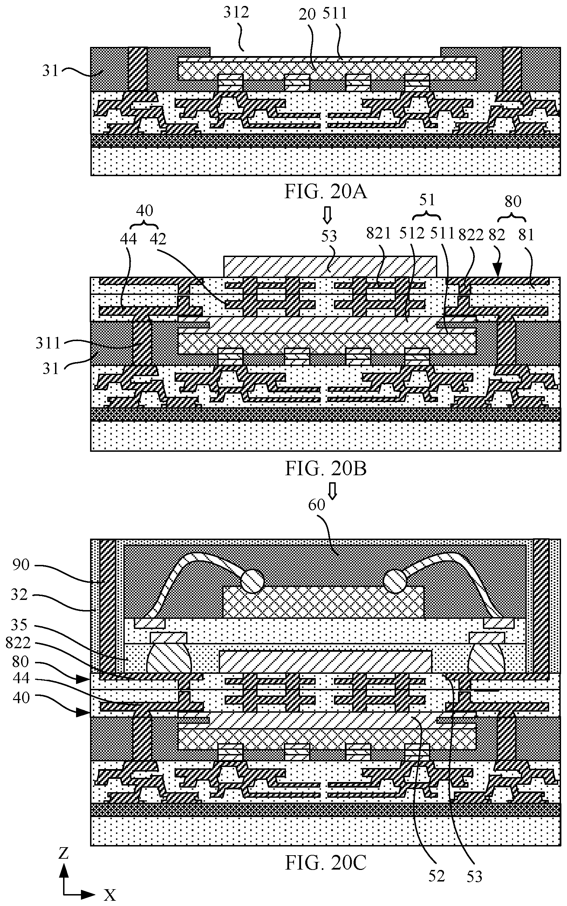

As shown in FIG. 20A, the groove 312 may be manufactured on the first dielectric layer 31 by using a laser grooving technique, and a part of a top surface of the first sub-thermal conductor 511 is exposed. In this embodiment, a size of the groove 312 in an X direction may be less than a size of the first sub-thermal conductor 511 in the X direction. In another embodiment, a size of the groove 312 in an X direction may alternatively be the same as a size of the first sub-thermal conductor 511 in the X direction.

S125: Manufacture a second sub-thermal conductor and a second carrier board.

As shown in FIG. 20B, before the second carrier board 40 is manufactured, the second sub-thermal conductor 512 may be manufactured. A part of the second sub-thermal conductor 512 is located in the groove, and is connected to the first sub-thermal conductor 511, to form a second thermal conductor 51, and the other part of the second sub-thermal conductor 512 extends out of the groove 312, that is, a top surface of the second sub-thermal conductor 512 is higher than a top surface of the first dielectric layer 31. Then, the second carrier board 40 is manufactured on the second thermal conductor 51 and the first dielectric layer 31. The second carrier board 40 includes a dielectric structure 41, a first conductive portion 42, and a second conductive portion 44. The first conductive portion 42 is connected to the second thermal conductor 51, and the second conductive portion 44 is connected to a conductor 311.

S126: Manufacture a third carrier board on the second carrier board.

As shown in FIG. 20B, the third carrier board 80 is manufactured on the second carrier board 40, and the third carrier board 80 includes a dielectric structure 81 and a conductive structure 82. The conductive structure 82 includes a first conductive portion 821, a communication portion (not shown in FIG. 20B), and a second conductive portion 822. The first conductive portion 821 is connected to the first conductive portion 42 of the second carrier board 40.

S127: Manufacture a first thermal conductor on the third carrier board.

As shown in FIG. 20B, the first thermal conductor 53 may be attached on the third carrier board 80, and the first thermal conductor 53 is connected to the first conductive portion 821 of the third carrier board 80.

S128: Manufacture a third thermal conductor on the third carrier board.

As shown in FIG. 20C, the third thermal conductor 90 may be attached on the third carrier board 80, and the third thermal conductor 90 is connected to the second conductive portion 822 of the third carrier board 80.

S129: Fasten a second chip to the third carrier board.

As shown in FIG. 20C, the second chip 60 may be soldered onto the second conductive portion 44 of the second carrier board 40 by using a surface mounted technique, and a bonding layer 35 is manufactured between the second chip 60 and the third carrier board 80 through underfill.

As shown in FIG. 20C, the second chip 60 is molded, to form a third dielectric layer 32. The third dielectric layer 32 may wrap the second chip 60 and the bonding layer 35, and a top surface of the third dielectric layer 32 is higher than a top surface of the second chip 60.

S1210: Remove the base plate.

The base plate 73 and a fourth dielectric layer 34 may be removed from the chip packaging structure 1 through debonding (debonding, DB). Then, a capacitor 71 is soldered to a bottom surface of a first conductive portion 12 of the first carrier board 10, and a first solder ball 72 is soldered to a bottom surface of a second conductive portion 13 of the first carrier board 10. The top surface of the third dielectric layer 32 is ground and thinned, to form the chip packaging structure 1 shown in FIG. 1.

The foregoing describes embodiments of this application with reference to the accompanying drawings. However, this application is not limited to the foregoing specific implementations. The foregoing specific implementations are merely examples instead of limitations. Inspired by this application, a person of ordinary skill in the art may further make modifications without departing from the purposes of this application and the protection scope of the claims, and all the modifications shall fall within the protection of this application.

## Claims

1. A chip packaging structure, comprising a first carrier board, a first chip, a second carrier board, and a second chip that are sequentially stacked, wherein the first chip is electrically connected to the first carrier board, and the second chip is electrically connected to the first carrier board through the second carrier board;
the chip packaging structure further comprises a first thermal conductor, the first thermal conductor is stacked between the first chip and the second chip, and a gap exists between the first thermal conductor and the second chip; and
the chip packaging structure further comprises a bonding layer, the bonding layer is located on a side that is of the second chip and that faces the second carrier board, and a part of the bonding layer is located in the gap.

2. The chip packaging structure according to claim 1, wherein the chip packaging structure further comprises a second thermal conductor, and the second thermal conductor is in contact with a surface that is of the first chip and that faces the second carrier board.

3. The chip packaging structure according to claim 2, wherein the second thermal conductor is located between the second carrier board and the second chip; and
the second carrier board comprises a dielectric structure and a first conductive portion, at least a part of the first conductive portion is disposed in the dielectric structure, and the first thermal conductor and the second thermal conductor are separately connected to the first conductive portion.

4. The chip packaging structure according to claim 2 or 3, wherein a thickness of the first thermal conductor is greater than a thickness of the second thermal conductor.

5. The chip packaging structure according to claim 3, wherein the second carrier board further comprises a second conductive portion, at least a part of the second conductive portion is disposed in the dielectric structure, a surface facing the second conductive portion is exposed from the dielectric structure and is connected to the second conductive portion, and the second conductive portion is electrically isolated from the first conductive portion.

6. The chip packaging structure according to claim 5, where the first conductive portion comprises a metal block, and a thickness of the metal block is the same as a thickness of the second carrier board.

7. The chip packaging structure according to claim 5, wherein the first conductive portion comprises a metal layer and a connection portion, a thickness of the metal layer is less than a thickness of the second carrier board, and the metal layer is separately connected to the second thermal conductor and the first thermal conductor through the connection portion.

8. The chip packaging structure according to any one of claims 3 to 7, wherein a material of the first thermal conductor comprises metal or silicon.

9. The chip packaging structure according to any one of claims 3 to 8, wherein the chip packaging structure further comprises a third thermal conductor, the third thermal conductor is located on a side that is of the second carrier board and that faces away from the first carrier board, and the third thermal conductor is thermally connected to the first conductive portion.

10. The chip packaging structure according to claim 9, wherein the chip packaging structure further comprises a third carrier board stacked between the second carrier board and the second thermal conductor, and the third thermal conductor is located on a side that is of the third carrier board and that faces away from the second carrier board; and
the third carrier board comprises a dielectric structure and a conductive structure, at least a part of the conductive structure is disposed in the dielectric structure, and the conductive structure is separately connected to the second thermal conductor, the third thermal conductor, and the first conductive portion.

11. The chip packaging structure according to claim 10, wherein the conductive structure comprises a first conductive portion and a second conductive portion that are disposed in a first direction, and a communication portion connected between the first conductive portion and the second conductive portion, the first conductive portion of the conductive structure corresponds in position to and is connected to the first conductive portion of the second carrier board, the third thermal conductor is disposed on the second conductive portion, and an included angle exists between the first direction and a thickness direction of the chip packaging structure.

12. The chip packaging structure according to claim 11, where the first conductive portion of the conductive structure comprises a metal block, and a thickness of the metal block of the conductive structure is the same as a thickness of the third carrier board.

13. The chip packaging structure according to claim 11, wherein the first conductive portion of the conductive structure comprises a metal layer and a connection portion, a thickness of the metal layer of the conductive structure is less than a thickness of the third carrier board, and the metal layer is connected to the second thermal conductor and the first conductive portion of the second carrier board through the connection portion.

14. The chip packaging structure according to claim 1, wherein the chip packaging structure further comprises a second thermal conductor, the first thermal conductor and the second thermal conductor are stacked between the first chip and the second chip, and a thickness of the first thermal conductor is greater than a thickness of the second thermal conductor.

15. The chip packaging structure according to claim 14, wherein the chip packaging structure further comprises a connection layer located between the first thermal conductor and the second thermal conductor.

16. The chip packaging structure according to claim 15, wherein the connection layer is a silver paste layer or a solder layer.

17. The chip packaging structure according to any one of claims 14 to 16, wherein a via is provided on the second carrier board, a part of the first thermal conductor is located in the via, and a top surface of the first thermal conductor is higher than a top surface of the second carrier board.

18. The chip packaging structure according to any one of claims 9 to 13, wherein a material of the third thermal conductor comprises metal or silicon.

19. An electronic device, comprising a circuit board and the chip packaging structure according to any one of claims 1 to 18, wherein the chip packaging structure is electrically connected to the circuit board.

20. A manufacturing method for a chip packaging structure, wherein the manufacturing method comprises:
manufacturing a first carrier board on a base plate;
fastening a first chip to the first carrier board;
manufacturing a second carrier board on the first carrier board;
manufacturing a first thermal conductor;
fastening a second chip to the second carrier board, wherein the first thermal conductor is located between the first chip and the second chip, and a gap exists between the first thermal conductor and the second chip;
manufacturing a bonding layer on a side that is of the second chip and that faces the second carrier board, wherein a part of the bonding layer is located between the second chip and the first thermal conductor; and
removing the base plate.

21. The manufacturing method according to claim 20, wherein after the step of fastening the first chip to the first carrier board, the manufacturing method further comprises:
manufacturing a second thermal conductor on the first chip, wherein the second thermal conductor is located between the first thermal conductor and the first chip, and a thickness of the second thermal conductor is less than a thickness of the first thermal conductor.

22. The manufacturing method according to claim 21, where the second carrier board comprises a dielectric structure and a first conductive portion, at least a part of the first conductive portion is disposed in the dielectric structure, and the first conductive portion is connected to the second thermal conductor; and
the step of manufacturing the first thermal conductor comprises:
manufacturing the first thermal conductor on the dielectric structure and the first conductive portion.

23. The manufacturing method according to claim 22, wherein after the step of manufacturing the second carrier board on the first carrier board, the manufacturing method further comprises:
manufacturing a third carrier board on the second carrier board, wherein the third carrier board comprises a dielectric structure and a conductive structure, at least a part of the conductive structure is disposed in the dielectric structure, and the conductive structure is connected to the first conductive portion; and
manufacturing a third thermal conductor on the third carrier board, wherein the conductive structure is connected to the third thermal conductor; and
the step of manufacturing the first thermal conductor comprises:
manufacturing the first thermal conductor on the third carrier board, wherein the first thermal conductor is connected to the conductive structure.
